(19) Europäisches Patentamt / European Patent Office / Office européen des brevets

(11) **EP 4 372 565 A1**

(12) **EUROPEAN PATENT APPLICATION**
published in accordance with Art. 153(4) EPC

(43) Date of publication:
**22.05.2024 Bulletin 2024/21**

(21) Application number: **22859972.6**

(22) Date of filing: **27.05.2022**

(51) International Patent Classification (IPC):
**G06F 11/30** (2006.01)  **G01R 31/36** (2020.01)

(52) Cooperative Patent Classification (CPC):
**G01R 31/36; G06F 11/30; H02J 7/00**

(86) International application number:
**PCT/CN2022/095663**

(87) International publication number:
**WO 2023/024624 (02.03.2023 Gazette 2023/09)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **23.08.2021 CN 202110968002**

(71) Applicant: **ZTE Corporation**
**Shenzhen, Guangdong 518057 (CN)**

(72) Inventor: **XIAO, Jianhua**
**Shenzhen, Guangdong 518057 (CN)**

(74) Representative: **Zoli, Filippo**
**Brunacci & Partners S.r.l.**
**Via Pietro Giardini, 625**
**41125 Modena (IT)**

(54) **METHOD AND APPARATUS FOR DISPLAYING CHARGING CAPACITY OF BATTERY, AND ELECTRICAL TERMINAL AND STORAGE MEDIUM**

(57)     A method and apparatus for displaying the capacity of a battery, and an electrical device and a storage medium. The method for displaying the charging capacity of a battery comprises: acquiring a first measured capacity and a first capacity change speed at a first moment, and using the first capacity change speed as the current capacity change speed; calculating and displaying a first capacity according to the first measured capacity and the current capacity change speed, wherein the precision of the first capacity is higher than the precision of the first measured capacity; moreover, periodically updating the current capacity change speed.

S1 — Start charging of the battery

S2 — Acquire a first measured electric quantity and a first electric quantity change speed, and take the first electric quantity change speed as a current electric quantity change speed

S3 — Calculate and display a first electric quantity according to the first measured electric quantity and the current electric quantity change speed, where the accuracy of the first electric quantity is higher than that of the first measured electric quantity

S4 — When a predetermined updating cycle is reached, determine whether the charging is completed

S5 — Acquire, if the charging is not completed, a second measured electric quantity, and calculate and display a second electric quantity according to the second measured electric quantity and the current electric quantity change speed, where the accuracy of the second electric quantity is higher than that of the second measured electric quantity

S6 — Update the current electric quantity change speed according to the second electric quantity and the second measured electric quantity to obtain a second electric quantity change speed

S7 — Take the second electric quantity change speed as the current electric quantity change speed

FIG. 1

EP 4 372 565 A1

## Description

### CROSS-REFERENCE TO RELATED APPLICATIONS

This application is filed on the basis of Chinese Patent Application No. 202110968002.X filed August 23, 2021, and claims priority to the Chinese Patent Application, the entire contents of which are incorporated herein by reference.

### TECHNICAL FIELD

The present disclosure relates to the technical field of electric devices, and more particularly, to a method and apparatus for displaying battery charging electric quantity, an electricity-consuming terminal device, and a storage medium.

### BACKGROUND

Electrical appliances, such as mobile phones, tablet computers, notebook computers and electrical vehicles, widely use batteries as their power supplies. With the development of fast charging technology, the charging speed of these electrical appliances is getting higher and higher. However, the existing mainstream fuel gauge hardware devices usually can only provide electric quantity data with an accuracy of 1%. Because of the low electric quantity accuracy of the existing fuel gauges, it is difficult for users to perceive the rapid change of electric quantity and the difference in charging speed during charging. Although the existing high-accuracy fuel gauges can provide accurate electric quantity data, such high-accuracy fuel gauges need to use software of electrical appliances to read electric quantity data at a high frequency and display it on a user interface. The high-frequency interaction between the user interface and the hardware device of the fuel gauge leads to high power consumption of the system and reduces the performance of the system. Such high-accuracy fuel gauges have a high cost, and require support of new hardware devices in electrical appliances, which greatly increases the manufacturing cost of electrical appliances.

### SUMMARY

The following is a summary of the subject matter described in detail herein. This summary is not intended to limit the protection scope of the claims.

Embodiments of the present disclosure provide a method and apparatus for displaying battery charging electric quantity, an electricity-consuming terminal device, and a storage medium.

In one aspect, an embodiment of the present disclosure provides a method for displaying battery charging electric quantity. The method includes: starting charging of the battery; acquiring a first measured electric quantity and a first electric quantity change speed, and taking the first electric quantity change speed as a current electric quantity change speed; calculating and displaying a first electric quantity according to the first measured electric quantity and the current electric quantity change speed, where the accuracy of the first electric quantity is higher than that of the first measured electric quantity; in response to reaching a predetermined updating cycle, determining whether the charging is completed; in response to the charging being not completed, acquiring a second measured electric quantity, and calculating and displaying a second electric quantity according to the second measured electric quantity and the current electric quantity change speed, where the accuracy of the second electric quantity is higher than that of the second measured electric quantity; updating the current electric quantity change speed according to the second electric quantity and the second measured electric quantity to obtain a second electric quantity change speed; and taking the second electric quantity change speed as the current electric quantity change speed, and returning to the step of acquiring the first measured electric quantity and the first electric quantity change speed and taking the first electric quantity change speed as the current electric quantity change speed.

Further, after starting the charging of the battery, the method further includes: detecting a charging power of the battery, and in response to the charging power being less than or equal to a predetermined power, acquiring and displaying a third measured electric quantity until the charging is completed, where the accuracy of the first electric quantity and the accuracy of the second electric quantity are higher than that of the third measured electric quantity.

Further, the method further includes: in response to the charging being completed, stopping display of the electric quantity or displaying charging completed.

Further, acquiring a first electric quantity change speed includes: acquiring a charging voltage and a charging current at a first moment corresponding to the first measured electric quantity; and determining the first electric quantity change speed according to the charging voltage and the charging current.

Further, calculating and displaying a first electric quantity according to the first measured electric quantity and the current electric quantity change speed includes: acquiring a first moment corresponding to the first measured electric quantity; acquiring a display moment of the first electric quantity; calculating a first time interval between the display moment and the first moment; and calculating the first electric quantity according to the first measured electric quantity, the current electric quantity change speed, and the first time interval.

Further, calculating and displaying a second electric quantity according to the second measured electric quantity and the current electric quantity change speed includes: acquiring a first moment corresponding to the first measured electric quantity; acquiring a second moment corresponding to the second measured electric quantity; calculating a second time interval between the first moment and the second moment; and calculating the second electric quantity according to the second measured electric quantity, the current electric quantity change speed, and the second time interval.

Further, updating the current electric quantity change speed according to the second electric quantity and the second measured electric quantity to obtain a second electric quantity change speed includes: in response to a difference between the second electric quantity and the second measured electric quantity being greater than a predetermined threshold, decreasing the current electric quantity change speed to obtain the second electric quantity change speed; and in response to a difference between the second measured electric quantity and the second electric quantity being greater than the predetermined threshold, increasing the current electric quantity change speed to obtain the second electric quantity change speed; where the predetermined threshold is a positive number.

In another aspect, an embodiment of the present disclosure provides an apparatus for displaying battery charging electric quantity. The apparatus includes: a starting module, configured for starting charging of the battery; a first acquisition module, configured for acquiring a first measured electric quantity and a first electric quantity change speed, and taking the first electric quantity change speed as a current electric quantity change speed; a first calculation and display module, configured for calculating and displaying a first electric quantity according to the first measured electric quantity and the current electric quantity change speed, where the accuracy of the first electric quantity is higher than that of the first measured electric quantity; a determining module, configured for determining, in response to reaching a predetermined updating cycle, whether the charging is completed; a second acquisition module, configured for acquiring a second measured electric quantity in response to the charging being not completed; a second calculation and display module, configured for calculating and displaying a second electric quantity according to the second measured electric quantity and the current electric quantity change speed, where the accuracy of the second electric quantity is higher than that of the second measured electric quantity; an updating module, configured for updating the current electric quantity change speed according to the second electric quantity and the second measured electric quantity to obtain a second electric quantity change speed; and a returning module, configured for taking the second electric quantity change speed as the current electric quantity change speed and returning the current electric quantity change speed to the first acquisition module.

In another aspect, an embodiment of the present disclosure provides an electricity-consuming terminal device. The terminal device includes: a battery, an electric quantity management module, a display module, at least one processor, a memory, and at least one computer program, where the at least one computer program is stored in the memory, and the at least one computer program includes instructions which, when executed by the terminal device, cause the terminal device to implement the method as described above.

In another aspect, an embodiment of the present disclosure provides a storage medium, storing a processor-executable program which, when executed by a processor, causes the processor to implement the method as described above.

**BRIEF DESCRIPTION OF DRAWINGS**

FIG. 1 is a flow chart of the steps of a method for displaying battery charging electric quantity in an embodiment of the present disclosure;

FIG. 2 is a schematic diagram of hardware devices involved in the charging of a battery in an embodiment of the present disclosure;

FIG. 3 is a diagram of a display effect of low-accuracy electric quantity in an embodiment of the present disclosure;

FIG. 4 is a diagram of a display effect of high-accuracy electric quantity in an embodiment of the present disclosure;

FIG. 5 is a schematic diagram of change of displayed electric quantity over time in an embodiment of the present disclosure; and

FIG. 6 is a schematic structural diagram of an apparatus for displaying battery charging electric quantity in an embodiment of the present disclosure.

**DETAILED DESCRIPTION**

In order to make the technical schemes and advantages of the disclosure clear, embodiments of the present disclosure will be illustrated in detail hereinafter in conjunction with the accompanying drawings. It should be noted that the embodiments in the present disclosure and the features in the embodiments may be arbitrarily combined with each other if not in collision.

In order to enable those having ordinary skills in the art to better understand the scheme of the present disclosure, the technical scheme in the embodiments of the present disclosure will be clearly and completely described below in conjunction with the accompanying drawings in the embodiments of the present disclosure. It is obvious that the described embodiments are merely part of the embodiments of the present disclosure rather than all of them. All other embodiments obtained by those having ordinary skills in the art based on the embodiments in the present disclosure without creative efforts shall fall within the protection scope of the present disclosure.

The terms "first", "second", "third", "fourth" and the like in the description, claims and accompanying drawings of the present disclosure are used to distinguish different objects, and are not used to describe a specific sequence. In addition, the terms "include" and "have" and any variations thereof are intended to cover non-exclusive inclusion. For example, a process, method, system, product or device that includes a series of steps or units is not limited to include the listed steps or units, but optionally includes steps or units that are not listed, or optionally includes other steps or units that are inherent to the process, method, product or device.

Reference to "an embodiment" herein means that a specific feature, structure or characteristic described in connection with an embodiment may be included in at least one embodiment of the present disclosure. The appearance of this phrase in various places of the present specification does not necessarily refer to the same embodiment, nor is it an independent or alternative embodiment mutually exclusive of other embodiments. It is understood by those having ordinary skills in the art both explicitly and implicitly that the embodiments described herein may be combined with other embodiments.

In the related art, electrical appliances, such as mobile phones, tablet computers, notebook computers and electrical vehicles, widely use batteries as power supplies. With the development of fast charging technology, the charging speed of these electrical appliances is getting higher and higher. However, the existing mainstream fuel gauge hardware devices can usually only provide electric quantity data with an accuracy of 1%. Because of the low electric quantity accuracy of mainstream fuel gauges in the existing technology, it is difficult for users to perceive the rapid change of electric quantity and the difference in charging speed during charging. For example, a battery of a mobile phone terminal may be charged from 0% to 100% within 40 minutes, at a rate of 0.04% per second. Because the electric quantity accuracy of an existing low-accuracy fuel gauge is only 1%, the mobile phone terminal can only display an electric quantity of for example 1%, 11% and 37%, and as a result, the user can only perceive the change of electric quantity by 1% after about 24 seconds, but the user will usually not stay in the charging interface for 24 seconds. Therefore, it is difficult for the user to perceive the change of electric quantity when plugging in a charger. Likewise, from the perspective of perceiving the difference in charging speed, it will take 40 minutes for a battery of a mobile phone terminal with high charging speed to be charged from 0 to 100% at a rate of about 1% every 24 seconds. It will take 60 minutes for a battery of another mobile phone terminal with low charging speed to be charged from 0 to 100% at a rate of about 1% every 36 seconds.

Therefore, the users of the two mobile phone terminals who stay in the charging interfaces for less than 24 seconds cannot perceive the difference in charging velocities between the two mobile phone terminals. If the accuracy of electric quantity displayed by a mobile phone terminal can reach 1/10,000, the mobile phone terminal can display the electric quantity of 1.12%, 11.25% and 37.86%, and a battery of the mobile phone terminal can be charged from 0 to 100% within 40 minutes. Therefore, after plugging in a charger, the user can see that the electric quantity of the mobile phone terminal is increased by about four points within one second, e.g., from 0.05% to 0.09%, or the user can see that the electric quantity of the mobile phone terminal is increased by about eighty points within 20 seconds. High-accuracy electric quantity display enables the user to perceive the difference in charging speed more visually. Although the existing high-accuracy fuel gauges can provide accurate electric quantity data, such high-accuracy fuel gauges need to use the software of electrical appliances to read electric quantity data at a high frequency and display it on a user interface. The high-frequency interaction between the user interface and the hardware device of the fuel gauge leads to high power consumption of the system and thus reduces the performance of the system. Such high-accuracy fuel gauges have a high cost, and require support of new hardware devices in electrical appliances, which greatly increases the manufacturing cost of electrical appliances.

In view of the above, embodiments of the present disclosure provide a method and apparatus for displaying battery charging electric quantity, an electricity-consuming terminal device, and a storage medium. Charging of a battery is started; a first measured electric quantity and a first electric quantity change speed at a first moment are acquired, and the first electric quantity change speed is taken as a current electric quantity change speed; and a first electric quantity is calculated and displayed according to the first measured electric quantity and the current electric quantity change speed, where the accuracy of the first electric quantity is higher than that of the first measured electric quantity, thus obtaining a displayed high-accuracy electric quantity with a low-accuracy fuel gauge. When a predetermined updating cycle is reached, it is determined whether the charging is completed; if the charging is not completed, a second measured electric quantity at a second moment is acquired, and a second electric quantity is calculated and displayed according to the second measured electric quantity and the current electric quantity change speed, where the accuracy of the second electric quantity is higher than that of the second measured electric quantity; the current electric quantity change speed is updated according to the second electric quantity and the second measured electric quantity to obtain a second electric quantity change speed; the second electric quantity change speed is taken as the current electric quantity change speed, and the process returns to the step of calculating and displaying the first electric quantity according to the first measured electric quantity and the current electric quantity change speed, where the accuracy of the first electric quantity is higher than that of the first measured electric quantity. In order to prevent the difference between the displayed electric quantity and the value of electric quantity measured by the fuel gauge from being too large, the current electric quantity change speed is updated periodically, which is beneficial to the real-time display of an accurate high-accuracy electric quantity value and helping users to know the electric quantity of the battery and the change thereof in time, thus improving the user experience.

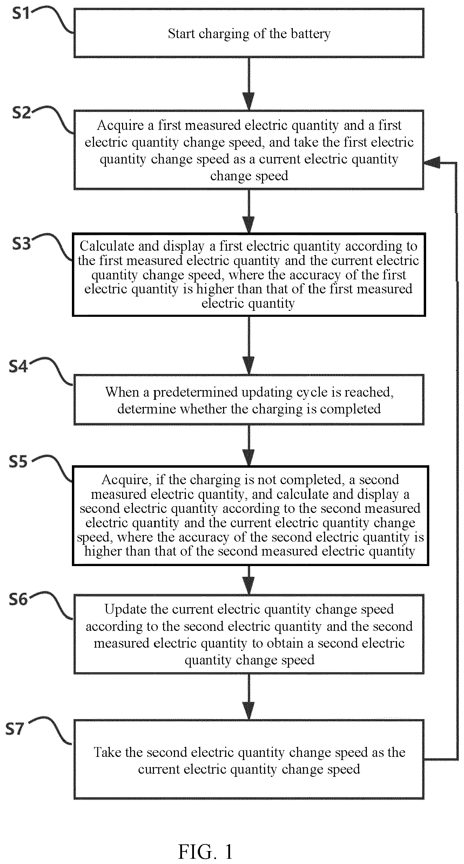

In an embodiment of the present disclosure, referring to FIG. 1, the method for displaying battery charging electric quantity includes the following steps S1 to S7.

At S1, charging of the battery is started.

At S2, a first measured electric quantity and a first electric quantity change speed are acquired, and the first electric quantity change speed is taken as a current electric quantity change speed.

At S3, a first electric quantity is calculated and displayed according to the first measured electric quantity and the current electric quantity change speed, where the accuracy of the first electric quantity is higher than that of the first measured electric quantity.

At S4, it is determined whether the charging is completed when a predetermined updating cycle is reached.

At S5, if the charging is not completed, a second measured electric quantity at a second moment is acquired, and a second electric quantity is calculated and displayed according to the second measured electric quantity and the current electric quantity change speed, where the accuracy of the second electric quantity is higher than that of the second measured electric quantity.

At S6, the current electric quantity change speed is updated according to the second electric quantity and the second measured electric quantity to obtain a second electric quantity change speed.

At S7, the second electric quantity change speed is taken as the current electric quantity change speed, and the process returns to S2.

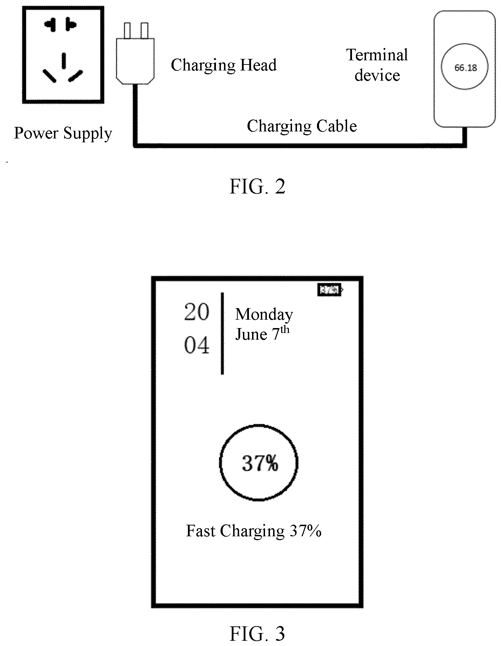

As shown in FIG. 2, the hardware components involved in the embodiment of the present disclosure mainly includes a power supply, a charging head, a charging cable, and a terminal device. The power supply may be a normal 220 V household power supply or a 380 V special power supply and a charging pile for electrical vehicles. The charging head and the charging cable may be separated, or combined together to be form a charger. The terminal device may be a mobile phone, a tablet computer, an electromobile, an electrical vehicle, or other types of rechargeable electricity-consuming terminal devices. In step S1, the charging of the battery may be started by connecting the power supply and the terminal device using the charging head and the charging cable. It can be understood by those having ordinary skills in the art that the circuit structure shown in FIG. 2 does not constitute a limitation to the present disclosure, and may include more or less components than shown, a combination of some components, or a different arrangement of components.

It is worth noting that in the embodiment of the present disclosure, after starting the charging of the battery, the method for displaying battery charging electric quantity further includes: detecting the charging power of the battery, and if the charging power is less than or equal to a predetermined power, acquiring and displaying a third measured electric quantity until the charging is completed, where the accuracy of the first electric quantity and the accuracy of the second electric quantity are higher than that of the third measured electric quantity. The detecting the charging power of the battery may be monitoring an operating power of the charger, and whether the charger meets a predetermined power standard of the present disclosure may be determined according to the type and output capacity of the charger. In an embodiment using a mobile phone as an example of the present disclosure, it is detected that the charger supports Programmable Power Supply (PPS) protocol issued by the USB-IF organization, and the charger is considered a high-power charger if the maximum output is higher than or equal to 11 V/5 A. If the charging power is lower than 55 W, the charger is not considered a high-power charger, so there is no need to display a high-accuracy electric quantity, but rather a measurement result of a low-accuracy fuel gauge is displayed. It is worth noting that referring to FIG. 3, if the charging power is less than or equal to a predetermined power, a third measured electric quantity is acquired and displayed until the charging is completed, where the accuracy of the first electric quantity and the accuracy of the second electric quantity are higher than that of the third measured electric quantity. In an embodiment, if the charging power does not meet the standard of the above-mentioned high-power charger, there is no need to display a high-accuracy electric quantity. When the charging power of the battery is less than the predetermined power, only the display accuracy of an electric quantity indication, a charging display and a charging prompt on the screen of the terminal device is shown in percentile--37%. In another embodiment using an electrical vehicle as an example of the present disclosure, the charger is considered a high-power charger when it is detected that the charging power supply is a 380 V DC power supply, otherwise the charger is not a high-power charger. In a word, the standard for high power may be adjusted according to actual situations of the power supply and the terminal devices. It can be understood that the predetermined power standard for high power may be set according to specific situations. In an embodiment, different predetermined powers are selected for different rechargeable terminal devices, and the predetermined power settings listed above in the embodiment of the present disclosure are merely for illustration.

In step S2, a first measured electric quantity and a first electric quantity change speed are acquired, and the first electric quantity change speed is taken as a current electric quantity change speed. In the embodiment of the present disclosure, a low-accuracy fuel gauge, such as a fuel gauge with a percentile accuracy, is used to measure the electric quantity of the terminal device, i.e. a first measured electric quantity, and a charging voltage and a charging current at a first moment corresponding to the first measured electric quantity are acquired, and a first electric quantity change speed is determined according to the charging voltage and the charging current. In an embodiment, the charging voltage and the charging current at the first moment corresponding to the first measured electric quantity are acquired, so as to calculate the first electric quantity change speed. The first electric quantity change speed is calculated mainly using information about capacity, an actual charging voltage and an actual charging current of the battery. The first electric quantity change speed, denoted as V, may be identified by the following function:

$$V = f\ (FC,\ U,\ I,\ delta),$$

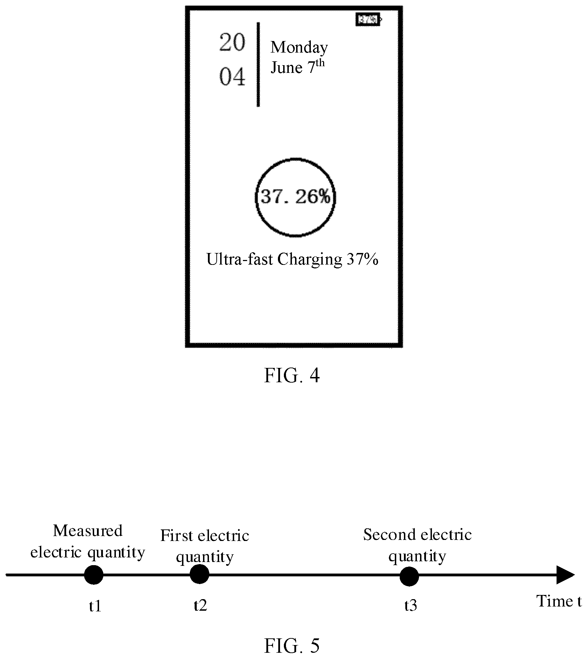

where FC represents the battery capacity, and the larger the battery capacity, the higher the unit capacity, and the slower the charging speed; U represents the charging voltage, and under the same other conditions, the higher the charging voltage, the higher the charging speed; I represents the charging current, and under the same other conditions, the higher the current, the higher the charging speed; the value of delta is a correction parameter for the charging speed, which is used to adjust the charging speed to avoid too great a difference from the value of the low-accuracy fuel gauge. If a low-accuracy electric quantity is found to be less than a calculated value of high-accuracy electric quantity after an updating cycle and a difference from the calculated value of high-accuracy electric quantity exceeds a predetermined threshold, delta is positive, indicating that the first electric quantity change speed V should be increased; and if the low-accuracy electric quantity is greater than the calculated value of high-accuracy electric quantity and the difference from the calculated value of high-accuracy electric quantity exceeds a predetermined threshold, delta is negative, indicating that the first electric quantity change speed V should be decreased. The terminal device is connected to the power supply by plugging in the charger, and after charging is started, an initial charging speed and delta (correction parameter) are determined through a table look-up method according to the charging voltage and the charging current. In this step, the first measured electric quantity measured by the fuel gauge is acquired, and the first electric quantity change speed is calculated and taken as the current electric quantity change speed within the first updating cycle, such that a high-accuracy electric quantity displayed in a display module of the terminal device can be calculated according to the first measured electric quantity and the current electric quantity change speed. The high-accuracy electric quantity refers to an electric quantity with an accuracy higher than that of the electric quantity measured by the fuel gauge. If the electric quantity measured by the fuel gauge is 37%, the high-accuracy electric quantity is at least 37.2%, and when the accuracy is ten-thousandth, two decimal places can be displayed, i.e., 0.01%, for example, the high-accuracy electric quantity is 37.26%, as shown in FIG. 4. It can be understood that the high-accuracy display standard may be set according to actual situations. In an embodiment, fuel gauges with different measurement accuracies correspond to different high-accuracy display standards, as long as the calculated and displayed high-accuracy electric quantity has an accuracy higher than that of the electric quantity measured by a fuel gauge. The low-accuracy electric quantity of 37% and the displayed high-accuracy electric quantity of 37.2% or 37.26% measured by the fuel gauges listed in the embodiment of the present disclosure are merely for illustration.

In step S3, the first electric quantity is calculated and displayed according to the first measured electric quantity and the current electric quantity change speed, where the accuracy of the first electric quantity is higher than that of the first measured electric quantity. Referring to FIG. 5, the first electric quantity change speed V1 of the battery at the first moment t1 may be acquired as the current electric quantity change speed. According to the first measured electric quantity L1, the first electric quantity change speed V1 and a first time interval (t2-t1) between a current moment t2 and the first moment t1, the first electric quantity L2 is determined. In an embodiment, the first electric quantity L2 may be calculated by the formula $L2 = L1 + V1 \times (t2 - t1)$. Through this step, the high-accuracy electric quantity can be calculated from the low-accuracy electric quantity measured by the fuel gauge and the electric quantity change speed, and displayed by the display module of the terminal device. Thus, under the condition that the fuel gauge actually has a low accuracy, a high-accuracy electric quantity can be displayed, especially in the case of a terminal device with a high charging speed, the charging speed can be well-displayed to improve the user experience.

In step S4, when the predetermined updating cycle is reached, it is determined whether the charging is completed. The predetermined updating cycle may refer to a cycle of re-reading the low-accuracy electric quantity of the fuel gauge, which is longer than a refresh cycle of an interface of the display module of the terminal device. For mobile phones, tablet computers, notebook computers, or other electrical appliances, the display module may be a built-in screen. For electrical vehicles and other electrical appliances, the display module may be a specially provided display such as a Nixie tube. The interface of the display module of the terminal device is refreshed, for example, every 50 milliseconds, and the cycle of reading the low-accuracy electric quantity of the fuel gauge may be 10 seconds, which means that the predetermined updating cycle may be 10 seconds. Because the reading of the fuel gauge consumes more energy for the terminal device and the refresh rate of the interface of the display module of the terminal device is relatively high, before the predetermined updating cycle is reached, the increase in the electric quantity only needs to be calculated from the low-accuracy electric quantity measured by the fuel gauge and the current electric quantity change speed. If the charging is completed when the predetermined updating cycle is reached, the display of electric quantity is stopped or charging completed is displayed. There are two conditions for the completion of charging: one is that the charger is unplugged from the mobile phone to stop charging, and the other is that the battery is fully charged. If any one of the two conditions is met, the charging process will end. It can be understood that the refresh cycle and the predetermined updating cycle of the interface of the display module of the terminal device may be set according to actual situations. In an embodiment, different rechargeable terminal devices correspond to different refresh cycles and updating cycles. The interface of the display module of the terminal device being refreshed every 50 milliseconds and the predetermined updating cycle being 10 seconds as described in the embodiment of the present disclosure are merely for illustration.

In step S5, if the charging is not completed, when the predetermined updating cycle is reached, a second measured electric quantity L3 of the fuel gauge is re-acquired, and a second high-accuracy electric quantity is calculated and displayed according to the second measured electric quantity and the current electric quantity change speed. Calculating and displaying the second electric quantity according to the second measured electric quantity and the current electric quantity change speed includes: acquiring a first moment t1 corresponding to the first measured electric quantity; acquiring a second moment t3 corresponding to the second measured electric quantity; calculating a second time interval (t3 - t1) between the first moment and the second moment; and calculating, according to the second measured electric quantity L3, the current electric quantity change speed V1 and the second time interval (t3 - t1), the second electric quantity as L4 = L3 + V1 × (t2 - t1). After the updating cycle is reached, the second electric quantity is still calculated according to the first electric quantity change speed acquired in S2. That is, before the current electric quantity change speed is updated, the electric quantity to be displayed in real time is still calculated according to the electric quantity change speed acquired previously.

In step S6, the current electric quantity change speed is updated according to the second electric quantity and the second measured electric quantity to obtain a second electric quantity change speed. When a difference between the second electric quantity and the second measured electric quantity is greater than a predetermined threshold, the current electric quantity change speed is decreased to obtain the second electric quantity change speed; and when a difference between the second measured electric quantity and the second electric quantity is greater than the predetermined threshold, the current electric quantity change speed is increased to obtain the second electric quantity change speed. The predetermined threshold is a positive number.

In an embodiment, the following scheme is adopted to calculate the second electric quantity change speed V2. The terminal device is connected to a power supply by plugging in a charger, to be charged, and then the first electric quantity change speed V1 and delta (correction parameter) of charging can be determined using a table look-up method according to a charging voltage and a charging current. Afterwards, after each updating cycle, the charging speed is adjusted according to a difference between a high-accuracy electric quantity (i.e., the second electric quantity L4) calculated in real time and a low-accuracy electric quantity (i.e., the second measured electric quantity L3) measured by the fuel gauge. An adjusted second electric quantity change formula is as follows:

$$V2 = V1 + (L4 / 100 - L3) * \text{Delta}.$$

For example, when the charger is plugged in, the low-accuracy electric quantity read by the fuel gauge is 20%. It is determined that an initial charging speed is 500/ms according to the charging voltage and the charging current, and the Delta is 300. Then after 500 milliseconds, the high-accuracy electric quantity is 20.01%, and V2 = 500 + (2001 / 100 - 20) * 300 = 500. After a certain time, if the high-accuracy electric quantity is 4011 and the low-accuracy electric quantity is 41, then V2 = 500 + (4011 / 100 - 41) * 300 = 800. That is, the high-accuracy electric quantity is less than the actual electric quantity, so the charging speed should be increased.

In step S7, the second electric quantity change speed is taken as the current electric quantity change speed, and the process returns to step S2. When returning to step S3, the second measured electric quantity measured at the second moment after the predetermined updating cycle is reached can be obtained as a first measured electric quantity after returning; and the updated current electric quantity change speed (i.e. the second electric quantity change speed) can be obtained as a first electric quantity change speed. This process is repeated until the charging is completed. There are two conditions for the completion of charging: one is that the charger is unplugged from the mobile phone to stop charging, and the other is that the battery is fully charged. If any one of the two conditions is met, the charging process will end. When the technical scheme of the present disclosure is adopted, Thus, under the condition that the fuel gauge actually has a low accuracy, a high-accuracy electric quantity can be displayed, especially in the case of a terminal device with a high charging speed, the charging speed can be well-displayed to improve the user experience.

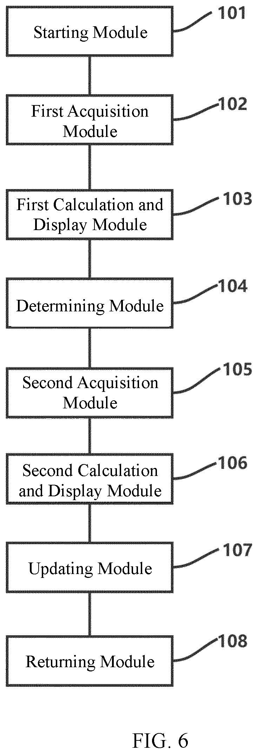

Referring to FIG. 6, an embodiment of the present disclosure provides an apparatus for displaying battery electric quantity during charging. The apparatus includes a starting module 101, a first acquisition module 102, a first calculation and display module 103, a determining module 104, a second acquisition module 105, a second calculation and display module 106, an updating module 107, and a returning module 108.

The starting module 101 is configured for starting charging of the battery.

The first acquisition module 102 is configured for acquiring a first measured electric quantity and a first electric quantity change speed and taking the first electric quantity change speed as a current electric quantity change speed.

The first calculation and display module 103 is configured for calculating and displaying a first electric quantity according to the first measured electric quantity and the current electric quantity change speed, where the accuracy of the first electric quantity is higher than that of the first measured electric quantity.

The determining module 104 is configured for determining whether the charging is completed when a predetermined updating cycle is reached.

The second acquisition module 105 is configured for acquiring a second measured electric quantity if the charging is not completed.

The second calculation and display module 106 is configured for calculating and displaying a second electric quantity according to the second measured electric quantity and the current electric quantity change speed, where the accuracy of the second electric quantity is higher than that of the second measured electric quantity.

The updating module 107 is configured for updating the current electric quantity change speed according to the second electric quantity and the second measured electric quantity to obtain a second electric quantity change speed.

The returning module 108 is configured for taking the second electric quantity change speed as the current electric quantity change speed and returning the current electric quantity change speed to the first acquisition module.

Likewise, all the contents in the above method embodiment are applicable to the apparatus embodiment, and the specific functions achieved by the apparatus embodiment are the same as those of the above method embodiment, and the beneficial effects achieved are also the same as those achieved by the above method embodiment.

An embodiment of the present disclosure provides an electricity-consuming terminal device, including a battery, an electric quantity management module, a display module, at least one processor, a memory, and at least one computer program. The at least one computer program is stored in the memory and includes instructions which, when executed by the electricity-consuming terminal device, cause the electricity-consuming terminal device to implement the method as described above.

Likewise, all the contents in the above method embodiment are applicable to the embodiment of the electricity-consuming terminal device, and the specific functions achieved by the embodiment of the electricity-consuming terminal device are the same as those of the above method embodiment, and the beneficial effects achieved are also the same as those achieved by the above method embodiment.

An embodiment of the present disclosure provides a storage medium, storing a processor-executable program which, when executed by a processor, causes the processor to implement the method for displaying battery charging electric quantity in the embodiment of the present disclosure. By using the storage medium, the same technical effect as that of the method for displaying battery charging electric quantity in the embodiment of the application can be achieved.

The present disclosure has the following beneficial effects: according to the method for displaying battery charging electric quantity in the embodiment of the present disclosure, a first measured electric quantity and a first electric quantity change speed at a first moment are acquired, the first electric quantity change speed is taken as a current electric quantity change speed, and a first electric quantity is calculated and displayed according to the first measured electric quantity and the current electric quantity change speed, where the accuracy of the first electric quantity is higher than that of the first measured electric quantity, thus obtaining a displayed high-accuracy electric quantity with a low-accuracy fuel gauge. In order to prevent the difference between the values of the displayed electric quantity and the electric quantity measured by the fuel gauge from being too large, the current electric quantity change speed is updated periodically, which is beneficial to the real-time display of a high-accuracy electric quantity value and facilitates users to know the battery electric quantity and the change thereof in time, thus improving the user experience.

It should be noted that unless otherwise indicated, when a feature is described as being "fixed" or "connected" to another feature, it may be directly or indirectly fixed or connected to the another feature. In addition, the expressions "upper", "lower", "left", "right" and the like in the present disclosure are used merely relative to the mutual positional relationship between the various components in the accompanying drawings of the present disclosure. The singular forms, "a", "the" and "this", used in the present disclosure are also intended to include plural forms, unless otherwise clearly indicated in contexts. In addition, unless otherwise defined, the meanings of all the technical and scientific terms used in the embodiments are the same as the meanings understood normally by those having ordinary skills in the art. The terms used in the embodiments of the description are merely used to describe specific embodiments and are not intended to limit the present disclosure. The term, "and/or", used in the embodiments includes any combination of at least one related item listed.

It should be understood that although terms like "first", "second", "third" and the like may be adopted in the present disclosure to describe various elements, these elements should not be limited by such terms. Such terms are merely used to distinguish elements of the same type from one another. For example, without departing from the scope of the embodiments, the first element may also be called the second element, and similarly, the second element may also be called the first element. The use of any or all of the examples or exemplary languages ("for example", "such as", etc.) provided in the embodiments is merely intended to better describe the embodiments of the present disclosure, and does not limit the scope of the present disclosure, unless otherwise required.

It should be realized that the embodiments of the present disclosure may be carried out or implemented by computer hardware, a combination of hardware and software, or computer instructions stored in a non-temporary computer-readable memory. The method may be carried out in a computer program by utilizing a standard programming technique and a non-temporary computer-readable storage medium configured with the computer program, where the storage medium configured in such a way that a computer operates in a specific and predefined mode according to the method and the drawings described in the embodiments. Every program can communicate with a computer system by means of an advanced process or an object-oriented programming language. However, if needed, the program may be implemented by the assembly language or the machine language. In any case, the language may be a compiled language or an interpretive language. In addition, for this purpose, the program may run on a programmed specific integrated circuit.

In addition, the operation of the process described in the embodiments may be executed in any appropriate sequence, unless otherwise indicated in the embodiments or is apparently contradictory to contexts. The process (or variations and/or combination thereof) described in the embodiments may be executed under the control of at least one computer system configured with executable instructions, and may be implemented as codes (for example, executable instructions, at least one computer program or at least one application) executed together on at least one processor by hardware or a combination thereof. The computer program includes multiple instructions executable by at least one processor.

Further, the method may be implemented in any appropriate type of computing platform, including, but not limited to, a personal computer, a mini computer, a mainframe, a workstation, a networked or distributed computing environment, a self-contained or integrated computer platform, communication with a charged particle tool or other imaging devices, etc. Each aspect of the present disclosure can be implemented by machine-readable codes stored in a non-temporary storage medium or device (either mobile or integrated into a computer platform) such as a hard disk, an optical read and/or write storage medium, a RAM, a ROM or etc., such that it can be read by a programmable computer, and when read by the computer, the storage medium or device can be used to configure and operate the computer to execute the process described herein. In addition, all or part of the machine-readable codes can be transmitted via a wired or wireless network. When such a medium includes instructions or a program for implementing the above steps in combination with a microprocessor or other data processors, the disclosure described in the embodiments includes these and other different types of non-temporary computer-readable storage media. When programming is conducted according to the method and technique described by the present disclosure, the present disclosure further includes a computer itself.

The computer program can be applied to input data to execute the functions described in the embodiments, and thereby the input data are converted to generate output data for storage in a non-volatile memory. Output information may also be applied to at least one output device such as displays. In the embodiments of the present disclosure, converted data represent physical and tangible objects, including the specific visual depiction of physical and tangible objects generated on the display.

The above are merely some embodiments of the present disclosure, and the prevent disclosure is not limited thereto. Any modification, equivalent replacement, improvement and on the like made within principle of the present disclosure shall be included in the protection scope of the present disclosure, as long as the technical effects of the present disclosure is achieved with the same means. Various modifications and alterations may be made to the technical schemes and/or embodiments within the protection scope of the present disclosure.

**Claims**

1.   A method for displaying battery charging electric quantity, comprising:

    starting charging of the battery;
    acquiring a first measured electric quantity and a first electric quantity change speed, and taking the first electric quantity change speed as a current electric quantity change speed;
    calculating and displaying a first electric quantity according to the first measured electric quantity and the current electric quantity change speed, wherein the accuracy of the first electric quantity is higher than that of the first measured electric quantity;

determining whether the charging is completed, in response to reaching a predetermined updating cycle;

acquiring a second measured electric quantity, and calculating and displaying a second electric quantity according to the second measured electric quantity and the current electric quantity change speed, in response to the charging being not completed, wherein the accuracy of the second electric quantity is higher than that of the second measured electric quantity;

updating the current electric quantity change speed according to the second electric quantity and the second measured electric quantity to obtain a second electric quantity change speed; and

taking the second electric quantity change speed as the current electric quantity change speed, and returning to the step of acquiring the first measured electric quantity and the first electric quantity change speed and taking the first electric quantity change speed as the current electric quantity change speed.

2. The method for displaying battery charging electric quantity of claim 1, wherein after starting the charging of the battery, the method further comprises: detecting a charging power of the battery, and in response to the charging power being less than or equal to a predetermined power, acquiring and displaying a third measured electric quantity until the charging is completed, wherein the accuracy of the first electric quantity and the accuracy of the second electric quantity are higher than that of the third measured electric quantity.

3. The method for displaying battery charging electric quantity of claim 1 or 2, wherein the method further comprises:
in response to the charging being completed, stopping display of the charging electric quantity or displaying charging completed.

4. The method for displaying battery charging electric quantity of claim 1, wherein acquiring the first electric quantity change speed comprises:

acquiring a charging voltage and a charging current at a first moment corresponding to the first measured electric quantity; and
determining the first electric quantity change speed according to the charging voltage and the charging current.

5. The method for displaying battery charging electric quantity of claim 1, wherein calculating and displaying a first electric quantity according to the first measured electric quantity and the current electric quantity change speed comprises:

acquiring a first moment corresponding to the first measured electric quantity;
acquiring a display moment of the first electric quantity;
calculating a first time interval between the display moment and the first moment; and
calculating the first electric quantity according to the first measured electric quantity, the current electric quantity change speed, and the first time interval.

6. The method for displaying battery charging electric quantity of claim 1, wherein calculating and displaying a second electric quantity according to the second measured electric quantity and the current electric quantity change speed comprises:

acquiring a first moment corresponding to the first measured electric quantity;
acquiring a second moment corresponding to the second measured electric quantity;
calculating a second time interval between the first moment and the second moment; and
calculating the second electric quantity according to the second measured electric quantity, the current electric quantity change speed, and the second time interval.

7. The method for displaying battery charging electric quantity of claim 1, wherein updating the current electric quantity change speed according to the second electric quantity and the second measured electric quantity to obtain a second electric quantity change speed comprises:

in response to a difference between the second electric quantity and the second measured electric quantity being greater than a predetermined threshold, decreasing the current electric quantity change speed to obtain the second electric quantity change speed; and
in response to a difference between the second measured electric quantity and the second electric quantity being greater than a predetermined threshold, increasing the current electric quantity change speed to obtain the second electric quantity change speed;
wherein the predetermined threshold is a positive number.

8. An apparatus for displaying battery charging electric quantity, comprising:

a starting module, configured for starting charging of the battery;

a first acquisition module, configured for acquiring a first measured electric quantity and a first electric quantity change speed, and taking the first electric quantity change speed as a current electric quantity change speed;

a first calculation and display module, configured for calculating and displaying a first electric quantity according to the first measured electric quantity and the current electric quantity change speed, wherein the accuracy of the first electric quantity is higher than that of the first measured electric quantity;

a determining module, configured for determining, in response to reaching a predetermined updating cycle, whether the charging is completed;

a second acquisition module, configured for acquiring a second measured electric quantity in response to the charging being not completed;

a second calculation and display module, configured for calculating and displaying a second electric quantity according to the second measured electric quantity and the current electric quantity change speed, wherein the accuracy of the second electric quantity is higher than that of the second measured electric quantity;

an updating module, configured for updating the current electric quantity change speed according to the second electric quantity and the second measured electric quantity to obtain a second electric quantity change speed; and

a returning module, configured for taking the second electric quantity change speed as the current electric quantity change speed and returning the current electric quantity change speed to the first acquisition module.

9. An electricity-consuming terminal device, comprising a battery, an electric quantity management module, a display module, at least one processor, a memory, and at least one computer program, wherein the at least one computer program is stored in the memory and comprises instructions which, when executed by the electricity-consuming terminal device, cause the electricity-consuming terminal device to perform the method of any of claims 1 to 7.

10. A storage medium, storing a processor-executable program which, when executed by a processor, causes the processor-executable program to perform the method of any of claims 1 to 7.

S1
┌─────────────────────────────────────────┐
│        Start charging of the battery      │
└─────────────────────────────────────────┘

S2
┌─────────────────────────────────────────┐
│  Acquire a first measured electric quantity and a first │
│  electric quantity change speed, and take the first electric │
│  quantity change speed as a current electric quantity │
│                change speed               │
└─────────────────────────────────────────┘

S3
┌─────────────────────────────────────────┐
│  Calculate and display a first electric quantity according to │
│  the first measured electric quantity and the current electric │
│  quantity change speed, where the accuracy of the first │
│  electric quantity is higher than that of the first measured │
│              electric quantity            │
└─────────────────────────────────────────┘

S4
┌─────────────────────────────────────────┐
│  When a predetermined updating cycle is reached, │
│   determine whether the charging is completed │
└─────────────────────────────────────────┘

S5
┌─────────────────────────────────────────┐
│   Acquire, if the charging is not completed, a second │
│   measured electric quantity, and calculate and display a │
│  second electric quantity according to the second measured │
│   electric quantity and the current electric quantity change │
│  speed, where the accuracy of the second electric quantity is │
│  higher than that of the second measured electric quantity │
└─────────────────────────────────────────┘

S6
┌─────────────────────────────────────────┐
│   Update the current electric quantity change speed │
│  according to the second electric quantity and the second │
│   measured electric quantity to obtain a second electric │
│              quantity change speed        │
└─────────────────────────────────────────┘

S7
┌─────────────────────────────────────────┐
│  Take the second electric quantity change speed as the │
│       current electric quantity change speed │
└─────────────────────────────────────────┘

FIG. 1

Power Supply — Charging Head — Charging Cable — Terminal device — 66.18

FIG. 2

20
04

Monday
June 7th

37%

Fast Charging 37%

FIG. 3

20
04 | Monday
June 7th

37. 26%

Ultra-fast Charging 37%

FIG. 4

Measured electric quantity

First electric quantity

Second electric quantity

t1  t2  t3  Time t

FIG. 5

Starting Module — 101

First Acquisition Module — 102

First Calculation and Display Module — 103

Determining Module — 104

Second Acquisition Module — 105

Second Calculation and Display Module — 106

Updating Module — 107

Returning Module — 108

FIG. 6

## INTERNATIONAL SEARCH REPORT

| International application No. |
|---|
| **PCT/CN2022/095663** |

| A. | CLASSIFICATION OF SUBJECT MATTER |
|---|---|

G06F 11/30(2006.01)i; G01R 31/36(2019.01)i

According to International Patent Classification (IPC) or to both national classification and IPC

| B. | FIELDS SEARCHED |
|---|---|

Minimum documentation searched (classification system followed by classification symbols)

G06F,G01R

Documentation searched other than minimum documentation to the extent that such documents are included in the fields searched

Electronic data base consulted during the international search (name of data base and, where practicable, search terms used)

CNTXT ENTXT ENTXTC DWPI CNKI IEEE: 电池, 充电, 电量, 显示, 变化, 速度, 电量, 速度, 精度, 精确, battery, charg+, electric quantity, display+, chang+, speed, accuracy, accurately

| C. | DOCUMENTS CONSIDERED TO BE RELEVANT |
|---|---|

| Category* | Citation of document, with indication, where appropriate, of the relevant passages | Relevant to claim No. |
|---|---|---|
| A | CN 112492107 A (OPPO GUANGDONG MOBILE TELECOMMUNICATIONS CO., LTD.) 12 March 2021 (2021-03-12) description, paragraphs 33-109, and figures 1-10 | 1-10 |
| A | CN 110704279 A (OPPO GUANGDONG MOBILE TELECOMMUNICATIONS CO., LTD.) 17 January 2020 (2020-01-17) entire document | 1-10 |
| A | CN 103364735 A (HUNAN JIUTIAN TECHNOLOGY CO., LTD.) 23 October 2013 (2013-10-23) entire document | 1-10 |
| A | US 2011004428 A1 (MUROCHI HARUMI et al.) 06 January 2011 (2011-01-06) entire document | 1-10 |

| ☐ Further documents are listed in the continuation of Box C. | ☑ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **26 July 2022** | **09 August 2022** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2022/095663**

| Patent document cited in search report | | | Publication date (day/month/year) | Patent family member(s) | | | Publication date (day/month/year) |
|---|---|---|---|---|---|---|---|
| CN | 112492107 | A | 12 March 2021 | None | | | |
| CN | 110704279 | A | 17 January 2020 | None | | | |
| CN | 103364735 | A | 23 October 2013 | CN | 103364735 | B | 04 November 2015 |
| US | 2011004428 | A1 | 06 January 2011 | US | 8649988 | B2 | 11 February 2014 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110968002X